# EUROPEAN PATENT APPLICATION

(11) **EP 4 709 105 A1**
(43) Date of publication of application: **11.03.2026**
(21) Application number: 25714021.0
(22) Date of filing: 21.02.2025
(51) Int. Cl.: H10F 77/70, H10F 77/14, H10F 77/16, H10F 71/00

(54) **SOLAR CELL AND PREPARATION METHOD THEREFOR, AND PHOTOVOLTAIC MODULE**

(30) Priority: 04.07.2024 CN 202410891549
(71) Applicant: LONGi Green Energy Technology Co., Ltd., Xi'an, Shaanxi 710100 (CN)
(72) Inventor: ZHANG, Wenku, Xi'an, Shaanxi 710100 (CN); WANG, Wulin, Xi'an, Shaanxi 710100 (CN); XIE, Junxia, Xi'an, Shaanxi 710100 (CN); ZHAO, Zanliang, Xi'an, Shaanxi 710100 (CN); LIAN, Jinkun, Xi'an, Shaanxi 710100 (CN); YANG, Wenwei, Xi'an, Shaanxi 710100 (CN); HAN, Peiyu, Xi'an, Shaanxi 710100 (CN); LU, Ke, Xi'an, Shaanxi 710100 (CN)
(74) Representative: Pfenning, Meinig & Partner mbB
(86) International application number: PCT/CN2025/078560
(87) International publication number: WO 2026/007427

(57) **Abstract**

The present application discloses a solar cell, a manufacturing method thereof, and a photovoltaic module, and relates to the field of solar cell technologies, to resolve a problem in the related art in which a sliced surface of a fragmented solar cell has a laser damage region, which affects performance such as passivation performance of the fragmented solar cell, and further affects photoelectric conversion efficiency of the fragmented solar cell. The solar cell includes a first surface and a second surface opposite to each other and a side surface connecting the first surface and the second surface. The side surface includes at least one first region; and the at least one first region includes a plurality of fused silicon regions and a first textured region located between at least two of the fused silicon regions.

## Description

### TECHNICAL FIELD

The present application relates to the field of solar cell technologies, and in particular, to a solar cell, a manufacturing method thereof, and a photovoltaic module.

### BACKGROUND

A solar cell is a device that uses solar energy and directly converts luminous energy into electrical energy through a photoelectric effect or a photochemical effect. The solar cell includes fragmented solar cells. Currently, a fragmented solar cell is usually manufactured by slicing a solar cell on which various film layers have been formed, to slice the entire solar cell into at least two fragmented solar cells, for example, two fragments. Subsequently, the fragmented solar cells are used for manufacturing a photovoltaic module.

However, after the slicing, a sliced surface of a fragmented solar cell usually has a laser damaged region. For example, a silicon substrate of the solar cell is partially fused by using a laser to open a guide slot for slicing. In this case, the fused silicon is recrystallized as a temperature reduces, partially oxidizes, and generates silicon slags and silicon oxide that are attached to a surface of the sliced surface. The foregoing situation affects performance such as passivation performance of the fragmented solar cell, and further affects photoelectric conversion efficiency of the fragmented solar cell.

### SUMMARY

An objective of the present application is to provide a solar cell, a manufacturing method thereof, and a photovoltaic module. A relative area and a distribution form of a fused silicon region are controlled, to improve a passivation characteristic and a light absorption characteristic of a laser damaged region, so that photoelectric conversion efficiency of the solar cell is improved.

To achieve the foregoing objective, according to a first aspect, the present application provides a solar cell. The foregoing solar cell includes a first surface and a second surface opposite to each other and a side surface connecting the first surface and the second surface. The side surface includes at least one first region; and the at least one first region includes a plurality of fused silicon regions and a first textured region located between at least two of the fused silicon regions.

During actual manufacture of a solar cell, generally, a side surface of the solar cell includes a "non-sliced side surface" that is not sliced and a "sliced side surface" that is formed after slicing. Generally, silicon slags and silicon oxide are not attached onto the non-sliced side surface, and even if there are silicon slags and silicon oxide attached to the surface, an amount of the silicon slags and silicon oxide attached to the surface is very small and can be ignored. Therefore, silicon slags and silicon oxide on the sliced side surface are mainly discussed and analyzed herein. An important source of the silicon slags and silicon oxide is that when a solar cell is sliced, a damaging laser is used to irradiate a silicon substrate of the solar cell, and the silicon substrate is fused after absorbing laser energy, and forms the silicon slags and silicon oxide through oxidation. A part of the silicon slags and silicon oxide that is remained after the processing is a fused silicon region in the present application. In the solar cell provided in the present application, the sliced side surface includes a first region, the region is a guide slot region opened by using a laser (a laser damaged sliced region), and at least two fused silicon regions in the first region include a first textured region therebetween. In this case, in comparison with a case in the related art in which a laser guide slot region on a sliced surface is full of silicon slags and silicon oxide, in the present application, an area and a distribution form of the fused silicon region on the sliced side surface are controlled, so that a relative area of the fused silicon region is within a suitable range. In addition, a first textured region is further included between the fused silicon regions. By using the first textured region and a side surface of the fused silicon regions, a light trapping effect of the side surface of the solar cell can be improved, and a light absorption rate can be increased. Further, a relatively regular form of the first textured region can improve film forming quality of a passivation layer, thereby improving the passivation effect.

In an implementation, in the first region, a ratio of a total area of the fused silicon regions to a total area of the first textured region is greater than or equal to 30% and less than or equal to 120%.

When the foregoing technical solution is used, the ratio of the total area of the fused silicon regions to the total area of the first textured region is within the foregoing range. This can reduce complexity of a manufacturing process caused by pursuing an excessively small total area of the fused silicon regions. In addition, light utilization of the side surface of the solar cell can also be ensured, and an overall passivation effect of the first region is optimized, to improve photoelectric conversion efficiency of the solar cell.

In an implementation, the plurality of fused silicon regions are distributed in the first region in a form of islands; and/or a maximum width of the fused silicon region is less than 100 µm.

When the foregoing technical solution is used, the plurality of fused silicon regions are distributed in the first region in a form of isolated islands. The plurality of fused silicon regions distributed in the form of islands facilitates reflection of more light to the first textured region through a side wall of the fused silicon regions, thereby improving the light trapping effect of the sliced side surface of the solar cell and increasing the light absorption rate, to improve the light utilization of the side surface of the solar cell. That the maximum width of the fused silicon region is less than 100 µm can further limit a size of the fused silicon region, and optimize the light trapping effect and the light absorbing efficiency.

In an implementation, a ratio of a width of the first region to a thickness of the solar cell is greater than or equal to 30% and less than or equal to 100%; and a width direction of the first region and a thickness direction of the solar cell are both consistent with a direction from the first surface to the second surface.

When the foregoing technical solution is used, when the ratio is greater than or equal to 30%, or the ratio is equal to 100%, it can be ensured that the formed first region is used as a guiding region to effectively segment the entire solar cell into two fragmented solar cells. Further, when the ratio is less than 100%, damage caused by the damaging laser to the solar cell can be reduced.

In an implementation, the first region includes a groove structure.

In an implementation, the groove structure extends in any one or more manners of a dendrite, a straight line, a folded line, or a curved line; and/or a depth of the groove structure ranges from 1 µm to 10 µm; and/or a cross section of the groove structure is any one or more of a V-shape or a U-shape.

In an implementation, the fused silicon regions include a stacked multi-layer structure; and/or the fused silicon regions include a porous structure; and/or the fused silicon regions include a silicon oxide.

In an implementation, the side surface further includes a second region, and the second region includes a second textured region.

When the foregoing technical solution is used, it is beneficial to improving a light trapping effect of the second region, so that more light is refracted from the second region into the solar cell and is used by the solar cell. In addition, in a process of manufacturing the solar cell, a passivation layer may be formed on the second region of the side surface of the solar cell, and a textured structure of the second textured region is beneficial to the passivation effect, to improve the photoelectric conversion efficiency of the solar cell.

In an implementation, the side surface includes a sliced side surface and a non-sliced side surface. The first region is located on the sliced side surface; and the second region is located on the sliced side surface and/or the non-sliced side surface.

When the foregoing technical solution is used, when the first region and the second region are both located on the sliced side surface of the solar cell, the sliced side surface includes the fused silicon region, the first textured region, and the second textured region. In comparison with a case in the related art in which a laser guide slot region on a sliced surface is full of silicon slags and silicon oxide, in the present application, an area and a distribution form of the fused silicon region on the sliced side surface are controlled, so that a relative area of the side fused silicon region is within a suitable range. In addition, the first textured region is further included between the fused silicon regions, and the sliced side surface further includes the second textured region. By using the first textured region and the second textured region, the light trapping effect of the side surface of the solar cell can be improved, and the light absorption rate can be increased. Further, a relatively regular form of the first textured region and the second textured region can improve film forming quality of the passivation layer, thereby improving the passivation effect.

In an implementation, the first textured region includes a suede structure, and the second textured region includes a suede structure. The suede structure included in the first textured region and the suede structure included in the second textured region both include pyramid structures.

When the foregoing technical solution is used, when the suede structures on the first textured region and the second textured region are the pyramid structures, it is beneficial to increasing a specific surface area of a side surface on which the first textured region and the second textured region are located. Based on this, the side surface on which the first textured region and the second textured region are located can have a good light trapping effect, thereby further improving the light utilization of the solar cell.

In an implementation, an average height of a pyramid structure of the first textured region is less than an average height of a pyramid structure of the second textured region, or an average bottom width of the pyramid structure of the first textured region is less than an average bottom width of the pyramid structure of the second textured region.

When the foregoing technical solution is used, it is beneficial to forming the passivation layer on the first textured region in a subsequent stage, to improve the passivation effect of the solar cell, and further improve the photoelectric conversion efficiency of the solar cell.

In an implementation, the first textured region includes a tower base-shaped structure, and the second textured region includes a tower base-shaped structure. A tower base transverse size of the tower base-shaped structure of the first textured region is smaller than a tower base transverse size of the tower base-shaped structure of the second textured region.

When the foregoing technical solution is used, it is beneficial to forming the passivation layer on the first textured region in a subsequent stage, to improve the passivation effect of the solar cell, and further improve the photoelectric conversion efficiency of the solar cell.

In an implementation, the tower base-shaped structure of the first textured region includes a convex structure or a concave structure; and the tower base-shaped structure of the second textured region includes a convex structure or a concave structure.

When the foregoing technical solution is used, the foregoing tower base-shaped structure of the convex structure or the concave structure can further increase roughness of the side surface on which the first textured region and the second textured region are located, thereby facilitating reducing reflectance of the side surface on which the first textured region and the second textured region are located, to further improve the light utilization of the solar cell.

In an implementation, the solar cell includes a first chamfer and a second chamfer opposite to each other. A side surface of the first chamfer includes the first region.

In an implementation, the length of an edge of the first chamfer is smaller than the length of an edge of the second chamfer.

When the foregoing technical solution is used, the first chamfer and the second chamfer can reduce or avoid damage caused by external stress to a corner of the solar cell, and reduce or eliminate a probability that the solar cell is damaged due to losing a corner, to ensure quality of the solar cell.

In an implementation, the solar cell further includes a passivation layer, and the passivation layer includes a part located on the side surface.

In an implementation, the passivation layer further includes a part located on the first surface and the second surface, the first surface is a light-facing surface, and an average thickness of the passivation layer located on the side surface is less than an average thickness of the passivation layer located on the first surface.

In an implementation, the solar cell further includes a passivation layer, the passivation layer including a first passivation layer and a second passivation layer. The first passivation layer includes a part located on the first surface or the second surface, the second passivation layer includes a part located on the sliced side surface, and an average thickness of the second passivation layer located on the sliced side surface is greater than an average thickness of the first passivation layer located on the first surface or the second surface.

In an implementation, the second passivation layer further includes a part located at an edge of the second surface close to the sliced side surface, and the part of the second passivation layer located at the edge of the second surface is located above the first passivation layer; and/or
the second passivation layer further includes a part located at an edge of the second surface close to the sliced side surface, and the part of the second passivation layer located at the edge of the second surface is located above the first passivation layer.

In an implementation, an average thickness of the second passivation layer located on the sliced side surface is greater than or equal to 10 nanometers and less than or equal to 120 nanometers; and/or an average thickness of the second passivation layer located at the edge of the first surface is less than the average thickness of the second passivation layer located on the sliced side surface; and/or the average thickness of the second passivation layer located at the edge of the second surface is less than the average thickness of the second passivation layer located on the sliced side surface.

In an implementation, a coverage ratio of the passivation layer in the first region is less than a coverage ratio of the passivation layer in a region other than the first region in the side surface; and/or a coverage ratio of the passivation layer in the first region is greater than 80%.

According to a second aspect, the present application further provides a manufacturing method of a solar cell. The manufacturing method of a solar cell includes the following steps:
First, provide a semiconductor substrate, the semiconductor substrate including a first surface and a second surface opposite to each other;
next, process the first surface by using a first laser process, to provide a slot on the first surface as a guide slot, where the slot extends along a first direction;
next, perform, by using a second laser process along the first direction, heat processing on a part in the first surface and located between the guide slots, to form a heat processing path;
next, segment the semiconductor substrate into at least two fragmented semiconductor substrates along the heat processing path; and
next, perform damage cleaning on a sliced surface included in the fragmented semiconductor substrate, where the sliced surface includes at least one first region, and the at least one first region includes a plurality of fused silicon regions and a first textured region located between at least two of the fused silicon regions.

When the foregoing technical solution is used, damage cleaning is performed on the sliced surface of the fragmented semiconductor substrate. In this case, a laser damaged layer generated due to the slicing of the first laser process can be removed, to reduce lattice defects.

During actual manufacture of a solar cell, generally, a side surface of the fragmented semiconductor substrate includes a "non-sliced surface" that is not sliced and a "sliced surface" that is formed after slicing. Generally, silicon slags and silicon oxide are not attached onto the non-sliced surface, and even if there are silicon slags and silicon oxide attached to the surface, an amount of the silicon slags and silicon oxide attached to the surface is very small and can be ignored. Therefore, silicon slags and silicon oxide on the sliced surface are mainly discussed and analyzed herein. An important source of the silicon slags and silicon oxide is that when a solar cell is sliced, a damaging laser is used to irradiate a silicon substrate of the solar cell, and the silicon substrate is fused after absorbing laser energy, and forms the silicon slags and silicon oxide through oxidation. A part of the silicon slags and silicon oxide that is remained after the processing is a fused silicon region in the present application. In the fragmented semiconductor substrate provided in the present application, the sliced surface includes a first region, the region is a guide slot region opened by using a laser (a laser damaged sliced region), and at least two fused silicon regions in the first region include a first textured region therebetween. In this case, in comparison with a case in the related art in which a laser guide slot region on a sliced surface is full of silicon slags and silicon oxide, in the present application, an area and a distribution form of the fused silicon region on the sliced surface are controlled, so that a relative area of the fused silicon region is within a suitable range. In addition, a first textured region is further included between the fused silicon regions. By using the first textured region and a side surface of the fused silicon regions, a light trapping effect of the side surface of the solar cell can be improved, and a light absorption rate can be increased. Further, a relatively regular form of the first textured region can improve film forming quality of a passivation layer, thereby improving the passivation effect.

In an implementation, after the performing damage cleaning on a sliced surface included in the fragmented semiconductor substrate, the manufacturing method of a solar cell further includes: forming a passivation layer on at least the sliced surface included in the fragmented semiconductor substrate.

When the foregoing technical solution is used, the passivation effect of the solar cell can be improved, to improve the photoelectric conversion efficiency of the solar cell. In addition, because the passivation layer is formed on the sliced surface of the fragmented semiconductor substrate after cleaning, under the action of the passivation layer, a surface dangling bond generated due to the sliced surface of the fragmented semiconductor substrate is directly exposed to air can be saturated. Based on this, life of minority carriers of the sliced surface can be improved, to reduce a composite current, thereby improving conversion efficiency and component power of the solar cell.

In an implementation, the slot includes a first part, a second part, and a third part; a first end of the first part and a first end of the second part are both connected to one end of the third part; a spacing between the first part and the second part gradually increases along a direction away from the third part; and a second end of the first part and a second end of the second part are close to an edge of the semiconductor substrate.

When the foregoing technical solution is used, the fragmented semiconductor substrate formed by slicing along the heat processing path includes a chamfer. In comparison with a case in which a corner of a sliced side of the fragmented semiconductor substrate is a right angle, damage caused by external stress to the corner of the fragmented semiconductor substrate can be reduced or avoided, and a probability that the fragmented semiconductor substrate is damage due to losing a corner can be reduced or eliminated, to ensure quality of the fragmented semiconductor substrate, and further the ensure quality of the solar cell.

In an implementation, an angle between the first part and the third part is equal to an angle between the second part and the third part.

In an implementation, a ratio of a depth of the slot to a thickness of the semiconductor substrate is greater than or equal to 30% and less than or equal to 100%, and a direction of the depth of the slot is the same as a direction of the thickness of the semiconductor substrate.

When the foregoing technical solution is used, when the ratio is greater than or equal to 30%, or the ratio is equal to 100%, it can be ensured that the formed first region is used as a guiding region to effectively segment the entire semiconductor substrate into two fragmented semiconductor substrates. Further, when the ratio is less than 100%, damage caused by the damaging laser to the semiconductor substrate can be reduced.

And/or, a damage-free hot laser is used as the second laser process.

When the foregoing technical solution is used, a damage-free hot laser is used for heat processing on the part of the entire semiconductor substrate located between the guide slots, so that damage to the semiconductor substrate can be reduced.

According to a third aspect, the present application further provides a photovoltaic module. The photovoltaic module includes:
a plurality of solar cells according to the first aspect, or a plurality of solar cells manufactured according to the manufacturing method of a solar cell according to the second aspect; an encapsulation layer, covering surfaces of the plurality of solar cells; and a cover plate, covering a surface of the encapsulation layer away from the solar cells.

### BRIEF DESCRIPTION OF THE DRAWINGS

The accompanying drawings described herein are used to provide a further understanding of the present application, and form a part of the present application. Exemplary embodiments of the present application and descriptions thereof are used to explain the present application, and do not constitute any inappropriate limitation to the present application. In the accompanying drawings:
FIG. 1 is a schematic structural diagram of a part of a sliced side surface of a solar cell when a ratio of a width of a first region to a thickness of the solar cell is less than 100% according to an embodiment of the present application;
FIG. 2 is a schematic structural diagram of a part of a sliced side surface of a solar cell when a ratio of a width of a first region to a thickness of the solar cell is equal to 100% according to an embodiment of the present application;
FIG. 3 is an SEM image of a part of a sliced side surface when a ratio of a width of a first region to a thickness of a solar cell is equal to 100% according to an embodiment of the present application;
FIG. 4 is an SEM image of other regions of a sliced side surface when a ratio of a width of a first region to a thickness of a solar cell is equal to 100% according to an embodiment of the present application;
FIG. 5 is a schematic diagram of a relationship between light and a solar cell according to an embodiment of the present application;
FIG. 6 is an SEM image when a second textured region is a tower base-shaped structure according to an embodiment of the present application;
FIG. 7 is a top view of a solar cell according to an embodiment of the present application;
FIG. 8 is a schematic diagram of a relationship between a semiconductor substrate, a slot, and a heat processing path according to an embodiment of the present application;
FIG. 9 is a top view of a slot according to an embodiment of the present application;
FIG. 10 is an SEM image of a part of a sliced surface of a fragmented semiconductor substrate after a semiconductor substrate is processed by using a damaging laser according to an embodiment of the present application; and
FIG. 11 is an SEM image of a part of a sliced surface of a fragmented semiconductor substrate after a semiconductor substrate is processed by using a damage-free hot laser according to an embodiment of the present application.

### Reference numerals:

1-side surface, 2- first region, 20-fused silicon region, 21-first textured region, 22-groove structure, 3-second region, 4-first chamfer, 5-second chamfer, 6-solar cell, 7-semiconductor substrate, 70-fragmented semiconductor substrate, 8-slot, 80-first part, 81-second part, and 82-third part.

### DETAILED DESCRIPTION

To make the technical problems to be resolved by, the technical solutions, and the beneficial effects of the present application clearer and more comprehensible, the following further describes the present application in detail with reference to the accompanying drawings and embodiments. It should be understood that, the specific embodiments described herein are merely used for describing the present application and are not used for limiting the present application.

It should be noted that, when an element is described as being "fixed to" or "arranged on" another element, the element may be directly located on the another element or indirectly located on the another element. When an element is described as being "connected to" another element, the element may be directly connected to the another element or indirectly connected to the another element.

In addition, the terms "first", "second", "third", and "fourth" are used merely for the purpose of description, and shall not be construed as indicating or implying relative importance or implying a quantity of indicated technical features. Therefore, a feature defined by "first", "second", "third", and "fourth" may explicitly or implicitly include one or more features. In the descriptions of the present application, "a plurality of" means two or more, unless otherwise definitely and specifically limited. "Several" means one or more, unless otherwise definitely and specifically limited.

In the descriptions of the present application, it should be understood that orientation or position relationships indicated by the terms such as "upper", "lower", "front", "rear", "left", and "right" are based on orientation or position relationships shown in the accompanying drawings, and are used only for ease and brevity of illustration and description of the present application, rather than indicating or implying that the mentioned apparatus or element needs to have a particular orientation or needs to be constructed and operated in a particular orientation. Therefore, such terms should not be construed as limiting of the present application.

In the descriptions of the present application, it should be noted that, unless otherwise explicitly stipulated and restricted, terms "installation", "joint connection", and "connection" should be understood broadly, which, for example, may be a fixed connection, or may be a detachable connection, or an integral connection; or may be a mechanical connection, or may be an electrical connection; or may be a direct connection, or may be an indirect connection by using a medium, or may be an internal communication between two components, or may be an interactive relationship between two components. A person of ordinary skill in the art may understand the specific meanings of the foregoing terms in the present application according to specific situations.

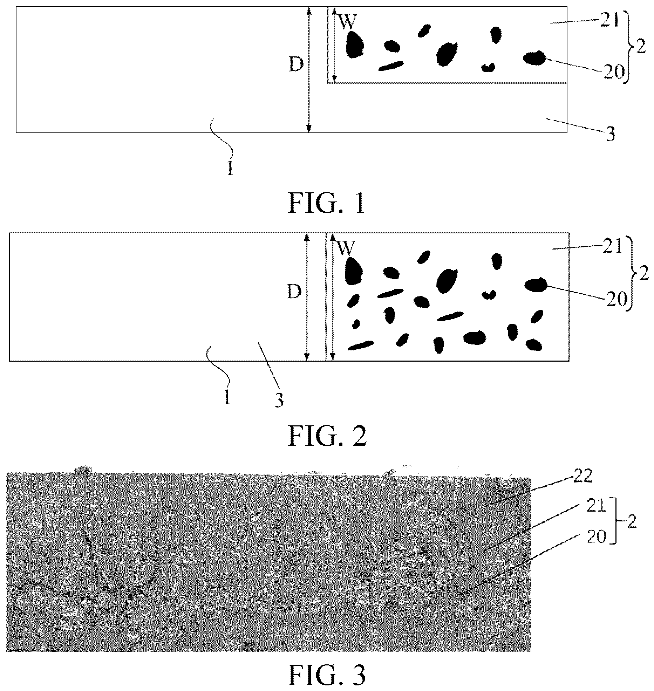

According to a first aspect, an embodiment of the present application provides a solar cell. Referring to FIG. 1 to FIG. 5, the foregoing solar cell includes a first surface and a second surface opposite to each other and a side surface 1 connecting the first surface and the second surface. The side surface 1 includes at least one first region 2; and the at least one first region 2 includes a plurality of fused silicon regions 20 and a first textured region 21 located between at least two of the fused silicon regions 20.

The foregoing solar cell may include a semiconductor substrate. For example, the foregoing semiconductor substrate may be a silicon substrate. In terms of conductivity types, the solar cell may be an intrinsic conductive base, an N-type conductive base, or a P-type conductive base. In an embodiment, the semiconductor substrate is an N-type conductive base or a P-type conductive base. Compared with the intrinsic conductive base, the N-type conductive base or the P-type conductive base has higher electrical conductivity. This helps to reduce a series resistance of the solar cell and improve efficiency of the solar cell. In terms of a structure, the first surface of the solar cell may be suede, to improve a light trapping effect of a light-facing surface of the solar cell, and further improve light utilization of the solar cell. It is clear that, the first surface of the solar cell may alternatively be a plane. The second surface of the solar cell may be a polished surface, or may be a suede surface. This is not specifically limited herein.

During actual manufacture of a solar cell, generally, a side surface of the solar cell includes a "non-sliced side surface" that is not sliced and a "sliced side surface" that is formed after slicing. Generally, silicon slags and silicon oxide are not attached onto the non-sliced side surface, and even if there are silicon slags and silicon oxide attached to the surface, an amount of the silicon slags and silicon oxide attached to the surface is very small and can be ignored. Therefore, silicon slags and silicon oxide on the sliced side surface are mainly discussed and analyzed herein. An important source of the silicon slags and silicon oxide is that when a solar cell is sliced, a damaging laser is used to irradiate a silicon substrate of the solar cell, and the silicon substrate is fused after absorbing laser energy, and forms the silicon slags and silicon oxide through oxidation. A region in which a part of the silicon slags and silicon oxide that is remained after the processing is located is the fused silicon region in this embodiment of the present application.

A quantity of the first regions may be determined according to an actual situation, for example, there may be one, two, three, four, or more first regions. Further, a position of the first region on the side surface of the solar cell may alternatively be set according to an actual situation, for example, in an upper-right corner region, a lower-right corner region, an upper-left corner region, a lower-left corner region, a middle upper region, a middle lower region, a left region, a right region, or a middle region of the sliced side surface included in the side surface. This depends on a specific fragmentation manner, for example, performing laser grooving on a light-facing surface or a back surface of the solar cell, and a depth of the laser grooving.

Generally, an entire solar cell may be sliced into fragments based on a division quantity N, to obtain N fragmented solar cells, where the division quantity N may be any positive integer greater than or equal to 2.

Three possible cases are used as examples for description below. It should be understood that the following descriptions are merely used for understanding and are not used for specific limitation.

Example 1: When the entire solar cell is sliced, if there is only one sliced side surface (to be specific, the entire solar cell is sliced into two fragmented solar cells along a length direction of the entire solar cell), and guide slots that do not penetrate are respectively opened by using lasers at two ends of a first surface of the entire solar cell. In this case, the side surface (or the sliced side surface) includes two first regions, and the two first regions are respectively located in an upper-right corner region and an upper-left corner region of the sliced side surface. It is clear that, the guide slots may alternatively be opened by using lasers on a second surface opposite to the first surface of the solar cell. In this case, two first regions are respectively located at a lower-right corner region and a lower-left corner region of the sliced side surface. In other words, the guide slots may be opened on the light-facing surface of the solar cell, or the guide slots may be opened on the back surface of the solar cell.

Example 2: When the entire solar cell is sliced, if there are two sliced side surfaces (to be specific, the entire energy cell is sliced into three fragmented solar cells along a length direction of the entire solar cell), and the two sliced side surfaces are respectively provided with guide slots that do not penetrate by using lasers at two ends of a first surface of the entire solar cell, in this case, a side surface of a middle fragmented solar cell includes four first regions, and the four first regions are respectively located in upper-right corner regions and upper-left corner regions of the two sliced side surfaces.

Example 3: When the entire solar cell is sliced, if there are two sliced side surfaces (to be specific, the entire energy cell is sliced into three fragmented solar cells along a length direction of the entire solar cell), the two sliced side surfaces are respectively provided with guide slots that do not penetrate by using lasers at two ends of a first surface of the entire solar cell, and further, a guide slot is added at a middle position of one of the sliced side surfaces, in this case, a side surface of a middle fragmented solar cell includes five first regions. For the first sliced side surface, two first regions are respectively located in an upper-right corner region and an upper-left corner region of the first sliced side surface. For the second sliced side surface, three first regions are respectively located in an upper-right corner region, an upper-left corner region, and a middle upper region of the second sliced side surface.

Referring to FIG. 1 to FIG. 3, in the solar cell provided in this embodiment of the present application, the sliced side surface includes a first region 2, the region is a guide slot region opened by using a laser (a laser damaged sliced region), and at least two fused silicon regions 20 in the first region 2 include a first textured region 21 therebetween. In this case, in comparison with a case in the related art in which a laser guide slot region on a sliced surface is full of silicon slags and silicon oxide, in this embodiment of the present application, an area and a distribution form of the fused silicon region 20 on the sliced side surface are controlled, so that a relative area of the fused silicon region 20 is within a suitable range. In addition, the first textured region 21 is further included between the fused silicon regions 20. By using the first textured region 21 and a side surface of the fused silicon regions, a light trapping effect of the side surface 1 of the solar cell can be improved, and a light absorption rate can be increased. Further, a relatively regular form of the first textured region 21 can improve film forming quality of a passivation layer, thereby improving the passivation effect.

In terms of a material, the fused silicon region 20 includes silicon and silicon oxide.

In a possible implementation, referring to FIG. 1, in the first region 2, a ratio of a total area of the fused silicon regions 20 to a total area of the first textured region 21 is greater than or equal to 30% and less than or equal to 120%. For example, the ratio of the total area of the fused silicon regions 20 to the total area of the first textured region 21 may be 30%, 40%, 50%, 60%, 70%, 80%, 90%, 100%, 120%, or the like.

The ratio of the total area of the fused silicon regions 20 to the total area of the first textured region 21 is within the foregoing range. This can reduce complexity of a manufacturing process caused by pursuing an excessively small total area of the fused silicon regions 20. In addition, light utilization of the side surface 1 of the solar cell can also be ensured, and an overall passivation effect of the first region is optimized, to improve photoelectric conversion efficiency of the solar cell.

In an implementation, the plurality of fused silicon regions 20 are dispersedly distributed in the first region.

In an implementation, a distribution range of maximum widths of the fused silicon regions 20 is large, and there are both a small fused silicon region and a large fused silicon region. A maximum width of a single fused silicon region 20 is preferably less than 100 µm, and an average maximum width of the fused silicon regions 20 in the first region 2 is preferably greater than or equal to 10 µm and less than or equal to 80 µm. For example, the average maximum width may be 10 µm, 20 µm, 50 µm, 60 µm, 70 µm, 80 µm, or the like. The maximum width of the fused silicon region is a maximum length of a line segment passing through the fused silicon region 20.

Referring to FIG. 1 to FIG. 5, in embodiments of the present application, the plurality of fused silicon regions are distributed in the first region in a form of isolated islands. The plurality of fused silicon regions distributed in the form of islands facilitates reflection of more light to the first textured region through a side wall of the fused silicon regions, thereby improving the light trapping effect of the sliced side surface of the solar cell and increasing the light absorption rate, to improve the light utilization of the side surface of the solar cell, so that the photoelectric conversion efficiency of the solar cell is improved. In an embodiment, projections of the fused silicon regions in the first region are irregular polygons, and are evenly distributed in the first region.

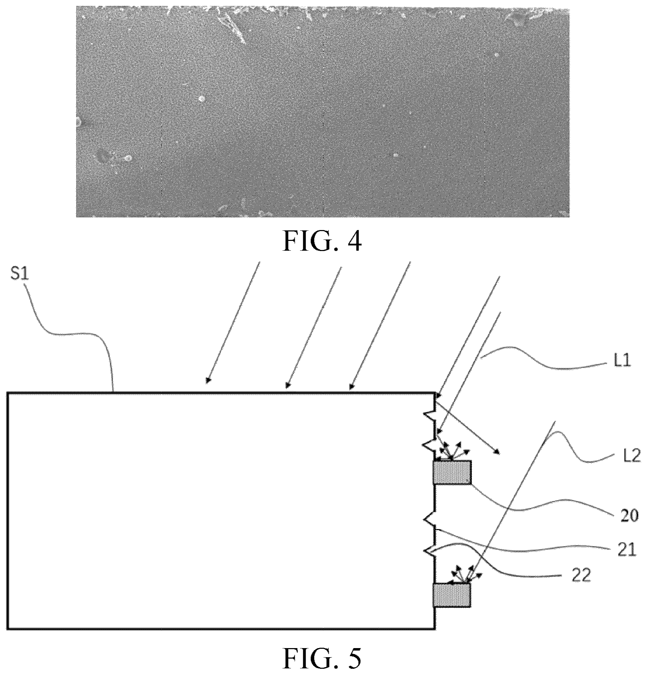

Referring to FIG. 5, it can be learned based on the foregoing descriptions that, the solar cell includes a first surface and a second surface opposite to each other. When the first surface S1 is a light-facing surface, and the second surface is a back surface, to better use light, an incident angle on the first surface of the solar cell is as close to 0° as possible. However, in this case, an incident angle of incident light on a side surface is very large, for example, close to 90°, and further, the light utilization of the side surface is very low. In this embodiment of the present application, the first region includes a plurality of fused silicon regions and the first textured region between the fused silicon regions. Therefore, the projections of the fused silicon regions in the first region are of irregular polygonal shapes, and are distributed in a form of isolated islands, where the distribution is uniform. In this case, it is beneficial to improving the light utilization of the side surface of the solar cell. For example, after incident light L1 and L2 in FIG. 5 pass through the fused silicon regions, more light can be reflected to the first textured region, to improve the light utilization ratio of the side surface of the solar cell. Further, a maximum width of a single fused silicon region 20 is preferably less than 100 µm, and an average maximum width of the fused silicon regions 20 in the first region 2 is preferably greater than or equal to 10 µm and less than or equal to 80 µm. This can balance light absorption and a light trapping effect.

In an embodiment, a thickness of the fused silicon region on the side surface is greater than or equal to 1 µm and less than or equal to 50 µm, and the thickness of the fused silicon region is a height difference between a top surface of the fused silicon region and the first textured region. For example, the thickness of the fused silicon region on the side surface may be 1 µm, 5 µm, 10 µm, 15 µm, 20 µm, 25 µm, 30 µm, 35 µm, 40 µm, 45 µm, 50 µm, or the like.

Further, the first region includes a micro crack, namely, a groove structure 22. The groove structure 22 extends in any one or more shapes such as a dendrite extension, a straight line extension, a folded line extension, and a curved line extension. As shown in FIG. 3 and FIG. 5, the groove structure 22 helps light to enter the side surface of the solar cell more deeply and enter the silicon substrate, thereby improving the light utilization. In an embodiment, a depth of the groove structure ranges from 1 µm to 10 µm; and a cross section of the groove structure is any one or more of a V-shape or a U-shape. A bottom and a side wall of the groove may be a flat plane structure or may be a suede structure. For example, the depth of the groove structure may be 1 µm, 2 µm, 3 µm, 4 µm, 5 µm, 6 µm, 7 µm, 8 µm, 9 µm, 10 µm, or the like.

Further, the fused silicon region may include a stacked multi-layer structure, and the layers are staggered at an edge of the fused silicon region. The stacked multi-layer structure is beneficial to increasing scattering of light from the edge of the fused silicon region. In addition, the fused silicon region includes a porous structure, which is more beneficial to enhancing light utilization.

In a possible implementation, referring to FIG. 1, a ratio of a width W of the first region 2 to a thickness D of the solar cell is greater than or equal to 30% and less than or equal to 100%; and a width direction of the first region 2 and a thickness direction of the solar cell are both consistent with a direction from the first surface to the second surface. For example, the ratio of the width of the first region to the thickness of the solar cell may be 30%, 35%, 40%, 45%, 50%, 55%, 60%, 65%, 70%, 75%, 80%, 85%, 90%, 95%, 100%, or the like.

When the foregoing technical solution is used, when the ratio is greater than or equal to 30%, or the ratio is equal to 100%, it can be ensured that the formed first region is used as a guiding region to effectively segment the entire solar cell into two fragmented solar cells. Further, when the ratio is less than 100%, damage caused by the damaging laser to the solar cell can be reduced.

For example, referring to FIG. 1, FIG. 1 is a schematic structural diagram of a part of a sliced side surface when the ratio of the width W of the first region 2 to the thickness D of the solar cell is less than 100%.

Referring to FIG. 2, FIG. 2 is a schematic structural diagram of a part of a sliced side surface when the ratio of the width W of the first region 2 to the thickness D of the solar cell is equal to 100%. FIG. 3 is an SEM image of a part of a sliced side surface when the ratio of the width of the first region 2 to the thickness of the solar cell is equal to 100%; and FIG. 4 is an SEM image of other regions of a sliced side surface when the ratio of the width of the first region to the thickness of the solar cell is equal to 100%.

In a possible implementation, referring to FIG. 1, the side surface 1 further includes a second region 3, and the second region 3 includes a second textured region, which facilitates improving a light trapping effect of the second region 3. In addition, in a process of manufacturing the solar cell, a passivation layer may be formed on the second region 3 of the side surface 1 of the solar cell, and a textured structure of the second textured region is beneficial to the passivation effect, to improve the photoelectric conversion efficiency of the solar cell.

With reference to the foregoing descriptions, the side surface includes a sliced side surface and a non-sliced side surface. The first region is located on the sliced side surface; and the second region is located on the sliced side surface and/or the non-sliced side surface.

For example, the first region and the second region are both located on the sliced side surface of the solar cell. Alternatively, the second region is located on the non-sliced side surface of the solar cell; and the first region is located on the sliced side surface of the solar cell. Alternatively, the first region is located on the sliced side surface of the solar cell; and the second region is located on the non-sliced side surface and the sliced side surface of the solar cell.

Referring to FIG. 1, when the first region 2 and the second region 3 are both located on the sliced side surface of the solar cell, the sliced side surface includes the fused silicon region 20, the first textured region 21, and the second textured region. In comparison with a case in the related art in which a laser guide slot region on a sliced surface is full of silicon slags and silicon oxide, in this embodiment of the present application, an area and a distribution form of the fused silicon region on the sliced side surface are controlled, so that a relative area of the side fused silicon region is within a suitable range. In addition, the first textured region is further included between the fused silicon regions, and the sliced side surface further includes the second textured region. By using the first textured region and the second textured region, the light trapping effect of the side surface of the solar cell can be improved, and the light absorption rate can be increased. Further, a relatively regular form of the first textured region and the second textured region can improve film forming quality of the passivation layer, thereby improving the passivation effect.

The structure included in the first textured region and the structure included in the second textured region may be the same or may be different. Further, the structure included in the first textured region and the structure included in the second textured region may be suede structures or tower base-shaped structures. Two possible cases are used as examples for description below. It should be understood that the following descriptions are merely used for understanding and are not used for specific limitation.

First case: The first textured region includes a suede structure, and the second textured region includes a suede structure (for example, the structure as shown in FIG. 4). The suede structure included in the first textured region and the suede structure included in the second textured region both include pyramid structures.

When the foregoing technical solution is used, when the suede structures on the first textured region and the second textured region are the pyramid structures, it is beneficial to increasing a specific surface area of a side surface on which the first textured region and the second textured region are located. Based on this, the side surface on which the first textured region and the second textured region are located can have a good light trapping effect, thereby further improving the light utilization of the solar cell.

Further, an average height of a pyramid structure of the first textured region is less than an average height of a pyramid structure of the second textured region, or an average bottom width of the pyramid structure of the first textured region is less than an average bottom width of the pyramid structure of the second textured region. In this case, it is beneficial to forming the passivation layer on the first textured region in a subsequent stage, to improve the passivation effect of the solar cell, and further improve the photoelectric conversion efficiency of the solar cell.

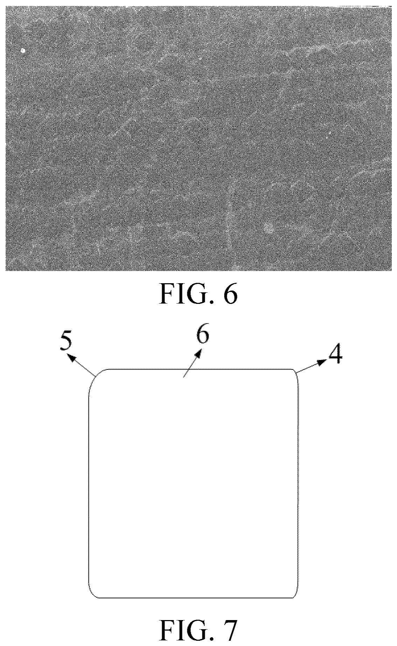

Second case: The first textured region includes a tower base-shaped structure, and the second textured region includes a tower base-shaped structure (the structure as sown in FIG. 6). A tower base transverse size of the tower base-shaped structure of the first textured region is smaller than a tower base transverse size of the tower base-shaped structure of the second textured region. In this case, it is beneficial to forming the passivation layer on the first textured region in a subsequent stage, to improve the passivation effect of the solar cell, and further improve the photoelectric conversion efficiency of the solar cell. It should be noted that, when a top view of the tower base is a quadrangle, a horizontal dimension of the tower base may be a length of any edge of the quadrangle or a length of a diagonal line.

In an implementation, the tower base-shaped structure of the first textured region includes a convex structure or a concave structure; and the tower base-shaped structure of the second textured region includes a convex structure or a concave structure.

The foregoing tower base-shaped structure of the convex structure or the concave structure can further increase roughness of the side surface on which the first textured region and the second textured region are located, thereby facilitating reducing reflectance of the side surface on which the first textured region and the second textured region are located, to further improve the light utilization of the solar cell.

In a possible implementation, referring to FIG. 7, the solar cell 6 includes a first chamfer 4 and a second chamfer 5 opposite to each other. A side surface of the first chamfer 4 includes the first region 2, and the length of an edge of the first chamfer 4 is smaller than the length of an edge of the second chamfer 5. The first chamfer 4 and the second chamfer 5 can reduce or avoid damage caused by external stress to a corner of the solar cell, and reduce or eliminate a probability that the solar cell is damaged due to losing a corner, to ensure quality of the solar cell.

For example, the solar cell 6 generally includes two first chamfers 4 and two second chamfers 5. The two first chamfers 4 are close to the sliced side surface, the two second chamfers 5 are close to a surface opposite to the sliced side surface, and the lengths of edges of the first chamfers 4 are smaller than the lengths of edges of the second chamfers 5.

In an implementation, the foregoing solar cell further includes a passivation layer, and the passivation layer may be located on the sliced side surface, the non-sliced side surface, the first surface, and the second surface. Several possible cases are used as examples for description below. It should be understood that the following descriptions are merely used for understanding and are not used for specific limitation.

Example 1: The passivation layer is disposed on the side surface (including the sliced side surface and the non-sliced side surface) of the solar cell.

Example 2: Passivation layers are disposed on the side surface (including the sliced side surface and the non-sliced side surface), the first surface, and the second surface of the solar cell, and are formed in a same process. In other words, a passivation layer on the side surface, a passivation layer on the first surface, and a passivation layer on the second surface are integrally formed and are distributed continuously. When the first surface is a light-facing surface, and the second surface is a back surface, the passivation layer on the second surface may be located only within a particular range of an edge of the second surface, for example, within 5 µm from the edge of the second surface. In addition, an average thickness of the passivation layer located on the side surface is less than an average thickness of the passivation layer located on the first surface. The passivation layer preferably includes at least one of aluminum oxide, silicon oxide, and silicon nitride.

Example 3: The passivation layer of the foregoing solar cell includes a first passivation layer and a second passivation layer. The first passivation layer includes a part located on the first surface or the second surface, the second passivation layer includes a part located on the sliced side surface, and an average thickness of the second passivation layer located on the sliced side surface is greater than an average thickness of the first passivation layer located on the first surface or the second surface.

Example 4: The passivation layer of the foregoing solar cell includes a first passivation layer and a second passivation layer. The first passivation layer includes a part located on the first surface and/or the second surface, the second passivation layer includes a part located on the sliced side surface, and an average thickness of the second passivation layer located on the sliced side surface is greater than an average thickness of the first passivation layer located on the first surface or the second surface. The second passivation layer further includes a part located at an edge of the second surface close to the sliced side surface, and the part of the second passivation layer located at the edge of the second surface is located above the first passivation layer; and/or the second passivation layer further includes a part located at an edge of the second surface close to the sliced side surface, and the part of the second passivation layer located at the edge of the second surface is located above the first passivation layer.

For example, the passivation layer of the foregoing solar cell includes the first passivation layer and the second passivation layer. The first passivation layer includes a part located on the first surface and/or the second surface; the second passivation layer includes a part located on the sliced side surface and a part located within a particular range of an edge close to the sliced side surface in the first surface and/or the second surface; and in the particular range of the edge close to the sliced side surface in the first surface and/or the second surface, the second passivation layer covers the first passivation layer, to implement a stacked structure of the first passivation layer and the second passivation layer. The first passivation layer and the second passivation layer may be formed in different process steps. Because the sliced side surface includes the first region, and the first region has the fused silicon region, the second passivation layer covering the sliced side surface can be formed in an independent step, thereby better satisfying a passivation requirement of the first region. In an embodiment, an average thickness of the second passivation layer located on the sliced side surface is greater than an average thickness of the first passivation layer located on the first surface or the second surface. The average thickness of the second passivation layer located on the sliced side surface is greater than or equal to 10 nm and less than or equal to 120 nm. For example, the average thickness of the second passivation layer located on the sliced side surface may be 10 nm, 30 nm, 50 nm, 80 nm, 90 nm, 100 nm, 120 nm, or the like. Materials of the first passivation layer and the second passivation layer may be selected from a group consisting of aluminum oxide, silicon oxide, and silicon nitride, and may include at least one of aluminum oxide, silicon oxide, and silicon nitride. A material and a structure of the first passivation layer may be the same as or different from that of the second passivation layer. The first passivation layer and the second passivation layer may be a single-layer film, or may be a stack of multi-layer films. Further, an average thickness of the second passivation layer located at the edge of the first surface is less than the average thickness of the second passivation layer located on the sliced side surface; and/or the average thickness of the second passivation layer located at the edge of the second surface is less than the average thickness of the second passivation layer located on the sliced side surface.

In a possible implementation, regarding the foregoing passivation layers formed at different positions, in the side surface of the solar cell, a coverage ratio of the passivation layer in the first region is less than a coverage ratio of the passivation layer in a region other than the first region in the side surface; or in the sliced side surface, a coverage ratio of the passivation layer in the first region 2 is less than a coverage ratio of the passivation layer in the second region 3. Because the first region has the fused silicon region, a surface structure of the first region is more complex than that of the second region 3. After the passivation layer is formed, the overall coverage ratio of the passivation layer in the first region is less than the overall coverage ratio of the passivation layer in the second region. In an embodiment, the coverage ratio of the passivation layer in the first region 2 is greater than 80%. In this way, an overall passivation effect of the first region can be ensured, and other problems such as an increase in process time and an increase in materials, caused by excessive disposition of the passivation layer are also avoided.

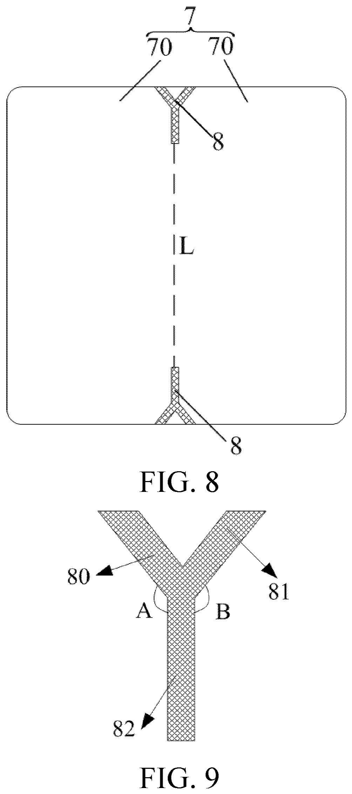

According to a second aspect, an embodiment of the present application further provides a manufacturing method of a solar cell. Referring to FIG. 8 to FIG. 11, the manufacturing method of a solar cell includes the following steps:
First, a semiconductor substrate 7 is provided, where the semiconductor substrate 7 includes a first surface and a second surface opposite to each other.

For example, the foregoing semiconductor substrate may be a silicon substrate. In terms of a conductivity type, the semiconductor substrate may be an intrinsic conductive substrate, an N-type conductive substrate, or a P-type conductive substrate. In an embodiment, the semiconductor substrate is the N-type conductive substrate or the P-type conductive substrate. Compared with the intrinsic conductive substrate, the N-type conductive substrate or the P-type conductive substrate has higher electrical conductivity. This helps to reduce a series resistance of the solar cell and improve efficiency of the solar cell.

Next, the semiconductor substrate is sliced into fragments. For example, the entire semiconductor substrate may be sliced into fragments based on a division quantity N, to obtain N fragmented semiconductor substrates, where the division quantity N may be any positive integer greater than or equal to 2. The first surface is processed by using a first laser process, to provide a slot 8 on the first surface, where the slot 8 extends along a first direction.

For example, a damaging laser is used as the first laser process. The slot formed on the semiconductor substrate is sliced by using the damaging laser as a guide slot, facilitating subsequent segmentation into the fragmented semiconductor substrates along the guide slot, to ensure that a shape of the fragmented semiconductor substrates satisfies an actual requirement.

In an example, a ratio of a depth of the slot to a thickness of the semiconductor substrate is greater than or equal to 30% and less than or equal to 100%, and a direction of the depth of the slot is the same as a direction of the thickness of the semiconductor substrate. For example, the ratio may be 30%, 35%, 40%, 45%, 50%, 55%, 60%, 65%, 70%, 75%, 80%, 85%, 90%, 95%, 100%, or the like.

When the foregoing technical solution is used, when the ratio is greater than or equal to 30%, or the ratio is equal to 100%, it can be ensured that the formed first region is used as a guiding region to effectively segment the entire semiconductor substrate into two fragmented semiconductor substrates. Further, when the ratio is less than 100%, damage caused by the damaging laser to the semiconductor substrate can be reduced.

Further, referring to FIG. 9, in a solution, the slot 8 includes a first part 80, a second part 81, and a third part 82. A first end of the first part 80 and a first end of the second part 81 are both connected to one end of the third part 82. A spacing between the first part 80 and the second part 81 gradually increases along a direction away from the third part 82; and a second end of the first part 80 and a second end of the second part 81 are close to an edge of the semiconductor substrate 7. For example, the slot may be a Y-shaped slot. In this case, a length direction of the third part 82 in the slot 8 is an extension direction of the slot, namely, the first direction.

When the foregoing technical solution is used, the fragmented semiconductor substrate formed by slicing along the heat processing path includes a chamfer. In comparison with a case in which at least two corners of the fragmented semiconductor substrate are right angles, damage caused by external stress to the corner of the fragmented semiconductor substrate can be reduced or avoided, and a probability that the fragmented semiconductor substrate is damage due to losing a corner can be reduced or eliminated, to ensure quality of the fragmented semiconductor substrate, and further the ensure quality of the solar cell.

In a possible implementation, referring to FIG. 9, an angle A between the first part 80 and the third part 82 is equal to an angle B between the second part 81 and the third part 82. Sizes of the two angles may be set according to an actual situation, and this is not specifically limited herein.

Next, heat processing is performed on the first surface by using a second laser process along the first direction, to form a heat processing path L.

For example, a damage-free hot laser is used as the second laser process. A damage-free hot laser is used for heat processing on the part of the entire semiconductor substrate located between the guide slots, so that damage to the semiconductor substrate can be reduced.

Next, the semiconductor substrate 7 is segmented into at least two fragmented semiconductor substrates 70 along the heat processing path L.

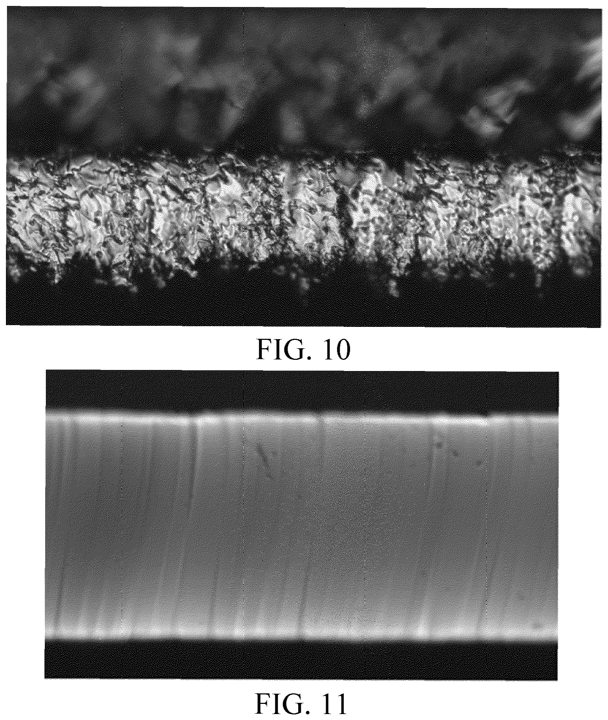

For example, after the heat processing path and the two slots are formed on the first surface of the semiconductor substrate, water is sprayed on the semiconductor substrate. In this case, the semiconductor substrate is naturally cracked, to form at least two fragmented semiconductor substrates. Referring to FIG. 10, FIG. 10 shows a case of a part of a sliced surface of a fragmented semiconductor substrate after a semiconductor substrate is processed by using a damaging laser. In FIG. 10, silicon slags and silicon oxide can be observed. Referring to FIG. 11, FIG. 11 shows a case of a part of a sliced surface of a fragmented semiconductor substrate after a semiconductor substrate is processed by using a damage-free hot laser. It can be observed in FIG. 11 that there is no silicon slag and no silicon oxide on the sliced surface.

Next, damage cleaning is performed on the sliced surface of the fragmented semiconductor substrate. In this case, a laser damaged layer generated due to the slicing of the first laser process can be removed, to reduce lattice defects.

For example, in a chain cleaning machine, the fragmented semiconductor substrate is placed into a slot of HF and HNO₃, and a part of the silicon slags and silicon oxide on the sliced surface of the fragmented semiconductor substrate are removed in a cleaning mode of a roller-carrying-liquid manner or a floating-on-water manner. Because the sliced surface is not protected by a phospho-silicate glass layer, concentrations of HF and HNO₃ are increased, to enhance corrosion on the sliced surface, thereby enhancing cleaning on the sliced surface, so that the sliced surface is smoother than a sliced surface in the related art, and a cleaning effect of the sliced surface is similar to a cleaning effect of another surface of the fragmented semiconductor substrate. Next, when the fragmented semiconductor substrate passes through a slot cleaning machine, alkaline texturing is performed and a ratio of an additive is adjusted, to perform texturing and corrosion on the sliced surface, so that effects of sides of the fragmented semiconductor substrate after texturing are similar, thereby improving a passivation effect of the solar cell after a passivation layer is formed on the fragmented semiconductor substrate subsequently.

The sliced surface includes at least one first region, and the at least one first region includes a plurality of fused silicon regions and a first textured region located between at least two of the fused silicon regions. For a quantity and positions of the first regions, refer to the descriptions in the first aspect, and details are not described herein again.

During actual manufacture of a solar cell, generally, a side surface of the fragmented semiconductor substrate includes a "non-sliced surface" that is not sliced (namely, the "non-sliced side surface" described in the first aspect) and a "sliced surface" that is formed after slicing (namely, the "sliced side surface" described in the first aspect). Generally, silicon slags and silicon oxide are not attached onto the non-sliced surface, and even if there are silicon slags and silicon oxide attached to the surface, an amount of the silicon slags and silicon oxide attached to the surface is very small and can be ignored. Therefore, silicon slags and silicon oxide on the sliced surface are mainly discussed and analyzed herein. An important source of the silicon slags and silicon oxide is that when a solar cell is sliced, a damaging laser is used to irradiate a silicon substrate of the solar cell, and the silicon substrate is fused after absorbing laser energy, and forms the silicon slags and silicon oxide through oxidation. A part of the silicon slags and silicon oxide that is remained after the processing is a fused silicon region in the present application. In the fragmented semiconductor substrate provided in the present application, the sliced surface includes a first region, the region is a guide slot region opened by using a laser (a laser damaged sliced region), and at least two fused silicon regions in the first region include a first textured region therebetween. In this case, in comparison with a case in the related art in which a laser guide slot region on a sliced surface is full of silicon slags and silicon oxide, in embodiments of the present application, a distribution area and a distribution form of the fused silicon region on the sliced surface are controlled, so that a relative area of the fused silicon region is within a suitable range. In addition, the first region further includes the first textured region. By using the first textured region 21 and a side surface of the fused silicon regions, a light trapping effect of the side surface 1 of the solar cell can be improved, and a light absorption rate can be increased. Moreover, a relatively regular form of the first textured region 21 can improve film forming quality of the passivation layer, thereby improving the passivation effect.

In an implementation, in the first region, a ratio of a total area of the fused silicon regions to a total area of the first textured region is greater than or equal to 30% and less than or equal to 120%. For example, the ratio of the total area of the fused silicon regions to the total area of the first textured region may be 30%, 40%, 50%, 60%, 70%, 80%, 90%, 100%, 110%, 120%, or the like.

The ratio of the total area of the fused silicon regions 20 to the total area of the first textured region 21 is within the foregoing range. This can reduce complexity of a manufacturing process caused by pursuing an excessively small total area of the fused silicon regions 20. In addition, light utilization of the side surface 1 of the solar cell can also be ensured, and an overall passivation effect of the first region is optimized, to improve photoelectric conversion efficiency of the solar cell. The plurality of fused silicon regions are distributed in the first region in a form of isolated islands. The plurality of fused silicon regions distributed in the form of islands facilitates reflection of more light to the first textured region through a side wall of the fused silicon regions, thereby improving the light trapping effect of the sliced surface of the solar cell and increasing the light absorption rate, to improve the light utilization of the side surface of the solar cell, so that the photoelectric conversion efficiency of the solar cell is improved. In an embodiment, projections of the fused silicon regions in the first region are irregular polygons, and are evenly distributed in the first region.

In a possible implementation, the sliced surface further includes a third region, and the third region includes a third textured region, which facilitates improving a light trapping effect and a passivation effect of the third region.

The structure included in the first textured region and the structure included in the third textured region may be the same or may be different. Further, the structure included in the first textured region and the structure included in the third textured region may be suede structures or tower base-shaped structures. Two possible cases are used as examples for description below. It should be understood that the following descriptions are merely used for understanding and are not used for specific limitation.

Example 1: The first textured region includes a suede structure, and the third textured region includes a suede structure. The suede structure included in the first textured region and the suede structure included in the third textured region both include pyramid structures.

When the foregoing technical solution is used, when the suede structures on the first textured region and the third textured region are the pyramid structures, it is beneficial to increasing a specific surface area of the sliced surface. Based on this, the sliced surface can have a good light trapping effect, thereby further improving the light utilization of the solar cell.

Because the first region includes a plurality of fused silicon regions, during wet processing, growth time of the first textured region in the first region is shorter than growth time of the third textured region in the third region. Therefore, an average height of a pyramid structure of the first textured region is less than an average height of a pyramid structure of the third textured region, or an average bottom width of the pyramid structure of the first textured region is less than an average bottom width of the pyramid structure of the third textured region.

Second case: The first textured region includes a tower base-shaped structure, and the third textured region includes a tower base-shaped structure. A tower base transverse size of the tower base-shaped structure of the first textured region is smaller than a tower base transverse size of the tower base-shaped structure of the third textured region. It should be noted that, when a top view of the tower base is a quadrangle, a horizontal dimension of the tower base may be a length of any edge of the quadrangle or a length of a diagonal line.

In an implementation, the tower base-shaped structure of the first textured region includes a convex structure or a concave structure; and the tower base-shaped structure of the third textured region includes a convex structure or a concave structure.

Compared with a planar tower base-shaped structure, the foregoing tower base-shaped structure of the convex structure or the concave structure can further increase roughness of the sliced surface, thereby facilitating reducing reflectance of the sliced surface, to further improve the light utilization of the solar cell.

It should be understood that, the semiconductor substrate further includes a side surface connecting the first surface and the second surface. Dividing by a final result of slicing, the side surface includes a sliced surface and a non-sliced surface. For descriptions of the sliced surface, refer to the foregoing specification, and details are not described herein again. The non-sliced surface may include a fourth textured region, and the fourth textured region may include a suede structure and a tower base-shaped structure. The suede structure may include a pyramid structure, and the tower base-shaped structure may include a convex structure or a concave structure. Sizes of the suede structure and the tower base-shaped structure of the third textured region and sizes of the suede structure and the tower base-shaped structure of the fourth textured region may be the same, or may be different. The sizes of the suede structure and the tower base-shaped structure of the fourth textured region are usually greater than sizes of the suede structure and the tower base-shaped structure of the first textured region.

After the performing damage cleaning on a sliced surface included in the fragmented semiconductor substrate, the manufacturing method of a solar cell further includes: forming a passivation layer on at least the sliced surface included in the fragmented semiconductor substrate.

In this case, the passivation effect of the solar cell can be improved, to improve the photoelectric conversion efficiency of the solar cell. In addition, because the passivation layer is formed on the sliced surface of the fragmented semiconductor substrate after cleaning, under the action of the passivation layer, a surface dangling bond generated due to the sliced surface of the fragmented semiconductor substrate is directly exposed to air can be saturated. Based on this, life of minority carriers of the sliced surface can be improved, to reduce a composite current, thereby improving conversion efficiency and component power of the solar cell.

In an implementation, the passivation layer includes a stacked multi-layer structure, for example, stacked films of aluminum oxide and silicon nitride. The passivation layer is located on a sliced surface of the semiconductor substrate, to improve a protection effect on the sliced surface.

When the foregoing technical solution is used, the stacked aluminum oxide passivation layer and silicon nitride passivation layer can perform passivation on the sliced surface, to reduce a recombination rate of carriers at the sliced surface, thereby further improving the photoelectric conversion efficiency of the solar cell. Further, the silicon nitride passivation layer may have an anti-reflection function, and this facilitates enabling more light to be refracted from the sliced surface into the semiconductor substrate, to further improve the light utilization of the solar cell.

A position of the step of "segmenting into fragments" described in the foregoing specification is described below by using manufacturing processes of two types of solar cells as examples. It should be understood that, the following descriptions are merely used for understanding and are not used for specific limitation.

The first type is a TOPCon solar cell. A manufacturing process of the TOPCon solar cell includes the following steps.

S1: Provide a semiconductor substrate.

S2: Perform cleaning and texturing processing on the semiconductor substrate.

S3: Perform boron diffusion and etching processing on the semiconductor substrate after texturing, to form a PN junction on a side of a light receiving surface of the semiconductor substrate.

S4: Perform polishing processing on a back surface of the semiconductor substrate, to remove a diffusion layer on the back surface of the semiconductor substrate.

S5: Successively form a tunnel oxide layer and a doped polycrystalline silicon layer on the back surface of the semiconductor substrate.

S6: Perform cleaning processing on the semiconductor substrate, to remove the PSG layer spread around the light receiving surface and the side surface of the semiconductor substrate, and remove the BSG layer on the light receiving surface and the PSG layer on the back surface.

S7: Form a passivation anti-reflection layer on a surface of the structure formed in the foregoing steps.

The step of "segmenting into fragments" described in the foregoing specification may be located at any position after S1 and before S6, for example, after S1 and before S2, or after S2 and before S3, or after S3 and before S4, or after S4 and before S5, or after S5 and before S6. After the segmentation into fragments is completed, medical liquid, process parameters, and the like in the cleaning processing in step S6 may be controlled, to obtain the solar cell according to the first aspect of the present application. In this embodiment, preferably, the first textured region includes a tower base-shaped structure, and the second textured region includes a tower base-shaped structure. In addition, in another case, the semiconductor substrate provided in step S1 is a pre-segmented semiconductor substrate, for example, the semiconductor substrate is segmented into fragments before entering a production procedure of the solar cell.

The second type is a BC solar cell. A first manufacturing process of the BC solar cell includes the following steps.

S1: Provide a semiconductor substrate, where the semiconductor substrate includes a first surface and a second surface opposite to each other.

S2: Perform cleaning processing on the semiconductor substrate.

S3: Form a first doped semiconductor material layer on an entire layer of the second surface.

S4: Perform patterning processing on the first doped semiconductor material layer, to form a first doped semiconductor layer on a part of regions of the second surface.

S5: Form a second doped semiconductor material layer on an entire layer of the second surface.

S6: Perform patterning processing on the second doped semiconductor material layer, so that the first doped semiconductor layer and a second doped semiconductor layer are spaced apart and alternately arranged.

S7: Perform cleaning and/or texturing processing on the semiconductor substrate.

S8: Form passivation anti-reflection layers on the first surface of the semiconductor substrate, the first doped semiconductor material layer, and the second doped semiconductor material layer.

The step of "segmenting into fragments" described in the foregoing specification may be located at any position after S1 and before S7, for example, after S1 and before S2, or after S2 and before S3, or after S3 and before S4, or after S4 and before S5, or after S5 and before S6, or after S5 and before S6, or after S6 and before S7. After the segmentation into fragments is completed, medical liquid, process parameters, and the like in step S7 may be controlled, to obtain the solar cell according to the first aspect of the present application. In addition, in another case, the semiconductor substrate provided in step S1 is a pre-segmented semiconductor substrate, for example, the semiconductor substrate is segmented into fragments before entering a production procedure of the solar cell.

A second manufacturing process of the BC solar cell includes the following steps.

S1: Provide a semiconductor substrate, where the semiconductor substrate includes a first surface and a second surface opposite to each other.

S2: Perform cleaning processing on the semiconductor substrate.

S3: Form a first doped semiconductor material layer on an entire layer of the second surface.

S4: Perform patterning processing on the first doped semiconductor material layer, to form a first doped semiconductor layer on a part of regions of the semiconductor substrate.

S5: Perform cleaning and/or texturing processing on the semiconductor substrate.

S6: Form passivation anti-reflection layers on the first surface of the semiconductor substrate, the first doped semiconductor material layer, and a region exposed outside the first doped semiconductor layer on the second surface of the semiconductor substrate.

The step of "segmenting into fragments" described in the foregoing specification may be located at any position after S1 and before S5, for example, after S1 and before S2, or after S2 and before S3, or after S3 and before S4, or after S4 and before S5. After the segmentation into fragments is completed, medical liquid, process parameters, and the like in step S5 may be controlled, to obtain the solar cell according to the first aspect of the present application. In addition, in another case, the semiconductor substrate provided in step S1 is a pre-segmented semiconductor substrate, for example, the semiconductor substrate is segmented into fragments before entering a production procedure of the solar cell.

According to a third aspect, an embodiment of the present application further provides a photovoltaic module. The photovoltaic module includes: a plurality of solar cells according to the first aspect, or solar cells manufactured according to the second aspect; an encapsulation layer, covering surfaces of the plurality of solar cells; and a cover plate, covering a surface of the encapsulation layer away from the solar cells.

In the descriptions of the foregoing implementations, the described specific features, structures, materials, or characteristics may be combined in a proper manner in any one or more of the embodiments or examples.

The foregoing descriptions are merely specific implementations of the present application, but are not intended to limit the protection scope of the present application. Any variation or replacement readily figured out by a person skilled in the art within the technical scope disclosed in the present application shall fall within the protection scope of the present application. Therefore, the protection scope of the present application shall be subject to the protection scope of the claims.

## Claims

1. A solar cell, the solar cell comprising a first surface and a second surface opposite to each other and a side surface connecting the first surface and the second surface; and
the side surface comprising at least one first region; and the at least one first region comprising a plurality of fused silicon regions and a first textured region located between at least two of the fused silicon regions.

2. The solar cell according to claim 1, wherein in the first region, a ratio of a total area of the fused silicon regions to a total area of the first textured region is greater than or equal to 30% and less than or equal to 120%.

3. The solar cell according to claim 1, wherein the plurality of fused silicon regions are distributed in the first region in a form of islands; and/or a maximum width of the fused silicon region is less than 100 µm.

4. The solar cell according to claim 1, wherein a ratio of a width of the first region to a thickness of the solar cell is greater than or equal to 30% and less than or equal to 100%; and a width direction of the first region and a thickness direction of the solar cell are both consistent with a direction from the first surface to the second surface.

5. The solar cell according to claim 1, wherein the first region comprises a groove structure.

6. The solar cell according to claim 5, wherein the groove structure extends in any one or more manners of a dendrite, a straight line, a folded line, or a curved line; and/or a depth of the groove structure ranges from 1 µm to 10 µm; and/or a cross section of the groove structure is any one or more of a V-shape or a U-shape.

7. The solar cell according to claim 1, wherein the fused silicon regions comprise a stacked multi-layer structure; and/or the fused silicon regions comprise a porous structure; and/or the fused silicon regions comprise a silicon oxide.

8. The solar cell according to any one of claims 1 to 7, wherein the side surface further comprises a second region, the second region comprising a second textured region.

9. The solar cell according to claim 8, wherein the side surface comprises a sliced side surface and a non-sliced side surface; and
the first region is located on the sliced side surface; and the second region is located on the sliced side surface and/or the non-sliced side surface.

10. The solar cell according to claim 8, wherein the first textured region comprises a suede structure, and the second textured region comprises a suede structure; the suede structure comprised in the first textured region and the suede structure comprised in the second textured region both comprising pyramid structures; and an average height of a pyramid structure of the first textured region being less than an average height of a pyramid structure of the second textured region, or an average bottom width of the pyramid structure of the first textured region being less than an average bottom width of the pyramid structure of the second textured region.

11. The solar cell according to claim 8, wherein the first textured region comprises a tower base-shaped structure, and the second textured region comprises a tower base-shaped structure; a tower base transverse size of the tower base-shaped structure of the first textured region being smaller than a tower base transverse size of the tower base-shaped structure of the second textured region.

12. The solar cell according to claim 11, wherein the tower base-shaped structure of the first textured region comprises a convex structure or a concave structure; and
the tower base-shaped structure of the second textured region comprises a convex structure or a concave structure.

13. The solar cell according to any one of claims 1 to 7, wherein the solar cell comprises a first chamfer and a second chamfer opposite to each other; a side surface of the first chamfer comprising the first region.

14. The solar cell according to claim 13, wherein the length of an edge of the first chamfer is smaller than the length of an edge of the second chamfer.

15. The solar cell according to any one of claims 1 to 7, wherein the solar cell further comprises a passivation layer, the passivation layer comprising a part located on the side surface.

16. The solar cell according to claim 15, wherein the passivation layer further comprises a part located on the first surface and the second surface; the first surface being a light-facing surface, and an average thickness of the passivation layer located on the side surface being less than an average thickness of the passivation layer located on the first surface.

17. The solar cell according to claim 9, wherein the solar cell further comprises a passivation layer, the passivation layer comprising a first passivation layer and a second passivation layer; and the first passivation layer comprises a part located on the first surface or the second surface, and the second passivation layer comprises a part located on the sliced side surface, an average thickness of the second passivation layer located on the sliced side surface being greater than an average thickness of the first passivation layer located on the first surface or the second surface.

18. The solar cell according to claim 17, wherein the second passivation layer further comprises a part located at an edge of the first surface close to the sliced side surface, and the part of the second passivation layer located at the edge of the first surface is located above the first passivation layer; and/or
the second passivation layer further comprises a part located at an edge of the second surface close to the sliced side surface, and the part of the second passivation layer located at the edge of the second surface is located above the first passivation layer.

19. The solar cell according to claim 18, wherein an average thickness of the second passivation layer located on the sliced side surface is greater than or equal to 10 nanometers and less than or equal to 120 nanometers; and/or an average thickness of the second passivation layer located at the edge of the first surface is less than the average thickness of the second passivation layer located on the sliced side surface; and/or the average thickness of the second passivation layer located at the edge of the second surface is less than the average thickness of the second passivation layer located on the sliced side surface.

20. The solar cell according to claim 15, wherein a coverage ratio of the passivation layer in the first region is less than a coverage ratio of the passivation layer in a region other than the first region in the side surface; and/or a coverage ratio of the passivation layer in the first region is greater than 80%.

21. A manufacturing method of a solar cell, comprising:
providing a semiconductor substrate, the semiconductor substrate comprising a first surface and a second surface opposite to each other;
processing the first surface by using a first laser process, to provide a slot on the first surface as a guide slot, the slot extending along a first direction;
performing, by using a second laser process along the first direction, heat processing on a part in the first surface and located between the guide slots, to form a heat processing path;
segmenting the semiconductor substrate into at least two fragmented semiconductor substrates along the heat processing path; and
performing damage cleaning on a sliced surface comprised in the fragmented semiconductor substrate; the sliced surface comprising at least one first region; and the at least one first region comprising a plurality of fused silicon regions and a first textured region located between at least two of the fused silicon regions.

22. The manufacturing method of a solar cell according to claim 21, wherein after the performing damage cleaning on a sliced surface comprised in the fragmented semiconductor substrate, the manufacturing method of a solar cell further comprises:
forming a passivation layer on at least the sliced surface comprised in the fragmented semiconductor substrate.

23. The manufacturing method of a solar cell according to claim 21, wherein the slot comprises a first part, a second part, and a third part; either of the first part and the second part comprising a first end far away from an edge of the semiconductor substrate and a second end close to the edge of the semiconductor substrate, and the first end of the first part and the first end of the second part both being connected to one end of the third part; and a spacing between the first part and the second part gradually increasing along a direction away from the third part; and
an angle between the first part and the third part is equal to an angle between the second part and the third part.

24. The manufacturing method of a solar cell according to claim 21, wherein a ratio of a depth of the slot to a thickness of the semiconductor substrate is greater than or equal to 30% and less than or equal to 100%, and a direction of the depth of the slot is the same as a direction of the thickness of the semiconductor substrate;
and/or a damage-free hot laser is used as the second laser process.

25. A photovoltaic module, comprising:
a plurality of solar cells according to any one of claims 1 to 20, or a plurality of solar cells manufactured by using the manufacturing method of a solar cell according to any one of claims 21 to 24;
an encapsulation layer, covering surfaces of the plurality of solar cells; and
a cover plate, covering a surface of the encapsulation layer away from the solar cells.
